# EUROPEAN PATENT APPLICATION

(11) **EP 3 780 081 A1**
(43) Date of publication of application: **17.02.2021**
(21) Application number: 19781137.5
(22) Date of filing: 11.03.2019
(51) Int. Cl.: H01L 23/12, H01L 23/14, H01L 23/15, H01L 23/36

(54) **ELECTRONIC MODULE AND MANUFACTURING METHOD THEREFOR**

(30) Priority: 03.04.2018 JP 2018071630
(71) Applicant: Sony Semiconductor Solutions Corporation, Atsugi-shi, Kanagawa 243-0014 (JP)
(72) Inventor: OZAKI, Hiroshi, Atsugi-shi, Kanagawa 243-0014 (JP); OKA, Shuichi, Atsugi-shi, Kanagawa 243-0014 (JP); YANAGAWA, Shusaku, Atsugi-shi, Kanagawa 243-0014 (JP)
(74) Representative: Müller Hoffmann & Partner
(86) International application number: PCT/JP2019/009590
(87) International publication number: WO 2019/193930

(57) **Abstract**

To achieve a module structure having a high heat dissipation property suitable for high-speed transmission.

An electronic module has a structure in which a device and a substrate on which the device is mounted are stacked. The substrate has a through hole that passes through from a device-mounted surface to a surface facing the device-mounted surface. The entire through hole is covered by the device on the device-mounted surface. The through hole may have a tapered shape in which open area expands from the device-mounted surface to the surface facing the device-mounted surface. A heat dissipation member can be formed in the through hole.

## Description

### TECHNICAL FIELD

The present technology relates to an electronic module. Specifically, the present technology relates to an electronic module having a device that is a heat source mounted on a substrate, and a manufacturing method thereof.

### BACKGROUND ART

In a small high-frequency front end module for communication used in a smartphone that is representative of a mobile device, the module is required to have a heat dissipation property because power consumption of a semiconductor mounted thereon is high. Furthermore, a module including an organic substrate, a ceramic/glass substrate, and the like is used to transmit high-frequency waves of several tens GHz in a next-generation 5G communication module.

In line with this, conventionally, proposed is a module in which a cavity is provided in a glass substrate and die-bonded so as to embed an integrated circuit (IC) chip in the cavity (for example, see Non-Patent Document 1). With this technology, a front surface of the IC chip becomes flush with a front surface of the glass, and insulation layers and wiring layers are formed thereon as many as required. In an IC chip package structure of this case, an opening portion is provided in an IC pad portion of an insulation layer, a sputter film or the like that is a plating base layer film is formed on the insulation layer and an upper portion of the IC pad, and a thick wiring layer is formed by electrolytic plating electrolysis or copper plating after forming plated resist. With this configuration, an inductor, a capacitor, and an impedance at a joint portion become smaller than those in packaging a solder bump and the like, and it is possible to achieve a joint advantageous at the time of high-speed transmission. Furthermore, as a similar structure, proposed is a package structure in which a copper heatsink is formed via an adhesive or the like on a back surface of an IC chip embedded in glass (for example, see Non-Patent Document 2).

### CITATION LIST

### NON-PATENT DOCUMENT

Non-Patent Document 1: Tailong Shi, et al.: "First Demonstration of Panel Glass Fan-out (GFO) Packages for High I/O Density and High Frequency Multi-Chip Integration", pp.41-46, IEEE 67th Electronic Components and Technology Conference (2017) .
Non-Patent Document 2: Venky Sundaram, et al.: "Integrated Copper Heat Slugs and EMI Shields in Panel Laminate (LFO) and Glass Fanout (GFO) Packages for High Power RF ICs", pp.300-305, IEEE 67th Electronic Components and Technology Conference (2017) .

### SUMMARY OF THE INVENTION

### PROBLEMS TO BE SOLVED BY THE INVENTION

In a conventional art described above, provided is a structure in which high-speed transmission is achieved by providing a cavity in a glass substrate and forming a thick wiring layer by electrolytic plating. However, glass has low thermal conductivity, and heat generated in an IC chip can hardly be dissipated through the glass. Furthermore, since an insulation layer on a front surface of the IC chip also has low thermal conductivity, heat generated from the IC chip can be dissipated only from the wiring layer at high thermal conductivity. Accordingly, there is a problem that a heat dissipation property of the IC chip is hardly obtained.

Furthermore, in a structure provided with a heatsink, an IC chip is die-bonded to a heat dissipation metal such as copper or the like via an adhesive such as a thermal interface material (TIM) or the like. Here, the TIM is generally a resin-mediated adhesive and has thermal conductivity whose value is one digit smaller than that of a metal. Accordingly, there is a problem that a sufficient heat dissipation property of the IC chip cannot be obtained also in respect of this structure.

The present technology is created in view of such situations and directed to achieving a module structure having a high heat dissipation property suitable for high-speed transmission.

### SOLUTIONS TO PROBLEMS

The present technology is made to solve the above-described problems, and a first aspect thereof is an electronic module including a device and a substrate on which the device is mounted, in which the substrate includes a through hole including a hole entirely covered by the device on a device-mounted surface, and the through hole passes through from the device-mounted surface to a surface facing the device-mounted surface. With this configuration, there is an operational effect that heat generated from the device is dissipated through the through hole.

Furthermore, in this first aspect, an open width of the through hole may be formed narrower than a width of the device on the device-mounted surface. With this configuration, there is an operational effect of ensuring accuracy of die-bonding and resist patterning at the time of manufacture.

Furthermore, in this first aspect, the through hole may have a tapered shape in which open area expands from the device-mounted surface to the surface facing the device-mounted surface. With this configuration, there is an operational effect that heat dissipation is more promoted.

Furthermore, in this first aspect, the open width of the through hole may be formed narrower than the width of the device at a position of less than 20 µm in a depth direction from the device-mounted surface. With this configuration, there is an operational effect of ensuring a distance from wiring even in a case of forming a heat dissipation member in the through hole.

Furthermore, in this first aspect, the substrate may include a glass substrate.

Furthermore, in this first aspect, the substrate may include a cavity, and the device may have a structure embedded in the cavity of the substrate.

Furthermore, in this first aspect, the substrate may include an organic substrate, and the device may have a structure built in the organic substrate.

Furthermore, in this first aspect, it may be possible to further include a heat dissipation member formed in the through hole. With this configuration, there is an operational effect that heat dissipation via the through hole is more promoted.

Furthermore, in this first aspect, it may be possible to further include: a wiring layer formed on the device-mounted surface in the substrate; through wiring that is connected to the wiring layer and passes through from the device-mounted surface to the surface facing the device-mounted surface in the substrate; and an electronic connection member connected to the through wiring. With this configuration, there is an operational effect that the surface facing the device-mounted surface is connected to the outside via the electronic connection member.

Furthermore, in this first aspect, it may be possible to further include: a wiring layer formed on the device-mounted surface in the substrate; and an electronic connection member connected to the wiring layer. With this configuration, there is an operational effect that the device-mounted surface is connected to the outside via the electronic connection member.

Moreover, a second aspect of the present technology is a method of manufacturing an electronic module, and the method includes: a procedure of mounting a device on a substrate; a procedure of opening, by etching, a hole in the substrate from a surface facing a device-mounted surface to the device-mounted surface, and generating an open hole covered by the device on the device-mounted surface; and a procedure of generating a heat dissipation metal in the open hole by electric field plating. With this configuration, there is an operational effect of manufacturing a module structure in which the open hole is provided from the device-mounted surface to a back surface, and heat generated in the device is dissipated via the heat dissipation metal.

### EFFECTS OF THE INVENTION

According to the present technology, it is possible to exert an excellent effect of achieving a module structure having a high heat dissipation property suitable for high-speed transmission. Note that the effect recited herein is not necessarily limited and may include any effect recited in the present disclosure.

### BRIEF DESCRIPTION OF DRAWINGS

Fig. 1 is a diagram illustrating an exemplary cross-sectional view of an electronic module in a first embodiment of the present technology.
Fig. 2 is a diagram illustrating exemplary dimensions of the electronic module in the first embodiment of the present technology.
Fig. 3 is a first half of a diagram illustrating an exemplary method of manufacturing the electronic module in the first embodiment of the present technology.
Fig. 4 is a latter half of the diagram illustrating the exemplary method of manufacturing the electronic module in the first embodiment of the present technology.
Fig. 5 is a diagram illustrating an exemplary cross-sectional view of an electronic module in a second embodiment of the present technology.
Fig. 6 is a first half of a diagram illustrating an exemplary method of manufacturing the electronic module in the second embodiment of the present technology.
Fig. 7 is a latter half of the diagram illustrating the exemplary method of manufacturing the electronic module in the second embodiment of the present technology.
Fig. 8 is a diagram illustrating an exemplary cross-sectional view of an electronic module in a third embodiment of the present technology.
Fig. 9 is a diagram illustrating an exemplary cross-sectional view of an electronic module in a fourth embodiment of the present technology.

### MODE FOR CARRYING OUT THE INVENTION

In the following, modes for carrying out the present technology (hereinafter referred to as "embodiments") will be described. The description will be provided in the following order.
1. First Embodiment (Example of Providing Heat Dissipation Metal in Open Hole of Glass Substrate)
2. Second Embodiment (Example of Providing Connection from Front Surface Side of Glass Substrate to Outside)
3. Third Embodiment (Exemplary Application to Structure Including Cavity in Glass Substrate)
4. Fourth embodiment (Exemplary Application to Structure Having IC Chip Built in Organic Substrate)

### <1. First Embodiment>

### [Structure]

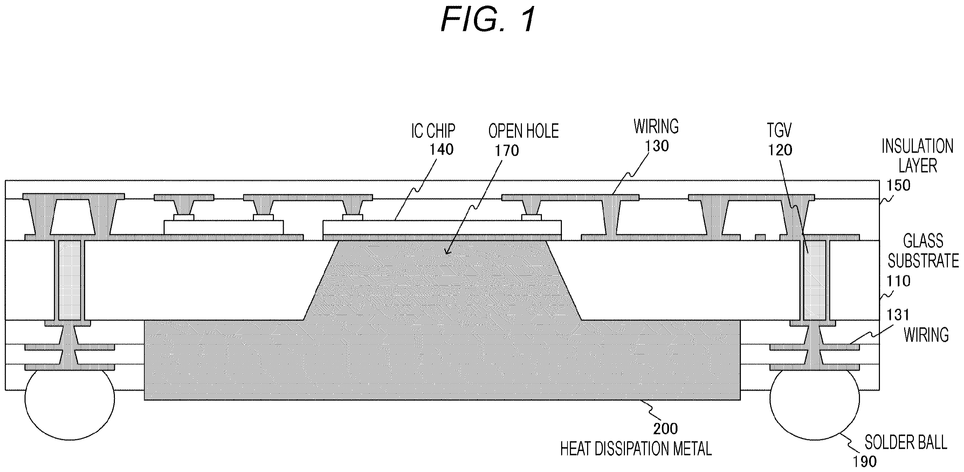

Fig. 1 is a diagram illustrating an exemplary cross-sectional view of an electronic module in a first embodiment of the present technology.

The electronic module in the first embodiment has a structure in which a glass substrate 110 and an IC chip 140 are stacked. That is, the IC chip 140 is die-bonded to the glass substrate 110. Note that the IC chip 140 is an example of a device described in claims. Furthermore, the glass substrate 110 is an example of a substrate described in the claims.

A wiring layer including wiring 130 and an insulation layer 150 are packaged on the IC chip 140 by plating or sputtering. With this configuration, a high-speed transmission property is ensured on a package surface of the IC chip 140. Note that copper (Cu) or the like is assumed as a material of the wiring 130.

Note that the glass substrate 110 is an example, and as far as a substrate is made for central high-frequency waves and has a relative dielectric constant of 12 or less, particularly, 6 or less, any substrate is applicable.

An open hole 170, as a through hole for heat dissipation, is formed from a mount surface having the IC chip 140 mounted (an upper surface in the same drawing) to a surface facing the mount surface (a lower surface in the same drawing) in the glass substrate 110. A heat dissipation metal 200 is formed in the open hole 170. The open hole 170 and the heat dissipation metal 200 have a tapered shape from a back surface of the IC chip 140 to a back surface of the glass substrate 110. Note that the open hole 170 is an example of a through hole described in the claims.

The heat dissipation metal 200 is a metal member to dissipate heat from the IC chip 140 that is a heat source. Copper (Cu) or the like is assumed as a material of the heat dissipation metal 200. When the heat dissipation metal 200 is packaged, the heat dissipation metal 200 is directly formed on the back surface of the IC chip 140 by sputtering, plating, or the like without using an adhesive such as a thermal interface material (TIM) or the like. That is, a material having poor thermal conductivity, like glass, does not exist on the back surface of the IC chip 140, and the IC chip 140 is directly connected to the heat dissipation metal 200 without including the adhesive like TIM and an interface with the adhesive. With this structure, a high heat dissipation property can be exerted by utilizing high heat conductivity of the metal. Note that the heat dissipation metal 200 is an example of a heat dissipation member described in the claims.

The heat dissipation metal 200 has the tapered shape from the back surface of the IC chip 140 to the back surface of the glass substrate 110. Additionally, the heat dissipation metal 200 forms a width sufficiently wider than a width of the IC chip 140 in a back surface portion of the glass substrate 110.

The glass substrate 110 includes a through glass via (TGV) 120 passing through from the mount surface having the IC chip 140 mounted to the surface facing the mount surface. The TGV 120 is connected to the wiring 130 on the mount surface having the IC chip 140 mounted, and the TGV 120 is connected to wiring 131 on the surface facing the mount surface having the IC chip 140 mounted. That is, this TGV 120 functions as connection wiring that connects wiring on both surfaces of the glass substrate 110. Note that the TGV 120 is an example of through wiring described in the claims.

A solder ball 190 is connected to the wiring 131 on the surface facing the mount surface having the IC chip 140 mounted. This solder ball 190 functions as an electronic connection member used to provide electronic connection to the outside of this electronic module. Note that the solder ball 190 is an example of an electronic connection member described in the claims.

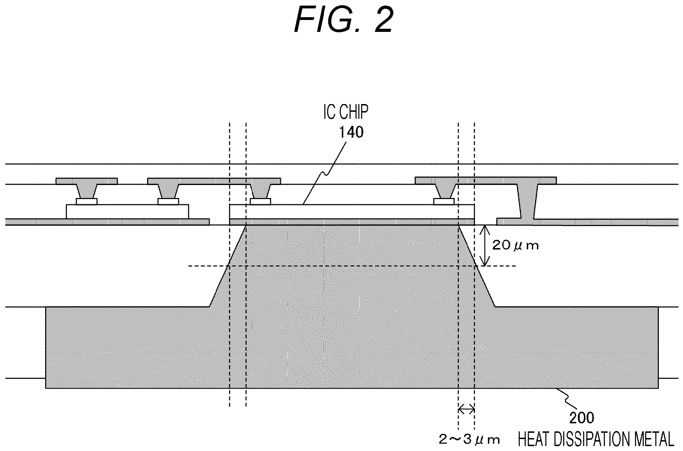

Fig. 2 is a diagram illustrating exemplary dimensions of the electronic module in the first embodiment of the present technology.

As for a width of the open hole 170, it is necessary to consider die-bonding accuracy of the IC chip 140 to the glass substrate 110, and patterning accuracy of resist to form the open hole 170 in the glass substrate 110. For example, it is desirable that the width of the open hole 170 be smaller than the width of the IC chip 140 by 2 to 3 µm or more on each side.

It is desirable that a tapered shape of the heat dissipation metal 200 do not exceed the width of the IC chip 140 and does not protrude to the outside in a range where a substrate thickness is less than 20 µm in a depth direction. With this structure, it is possible to constantly ensure the substrate thickness of 20 µm or more as a distance between the heat dissipation metal 200 and the wiring 130 on the package surface of the IC chip 140. Therefore, high-frequency characteristics of the glass substrate 110, such as a low dielectric constant and low dielectric loss tangent, can be utilized, and it is possible to prevent that high-speed transmission of the wiring 130 on the package surface of the IC chip 140 is adversely affected.

### [Manufacturing Method]

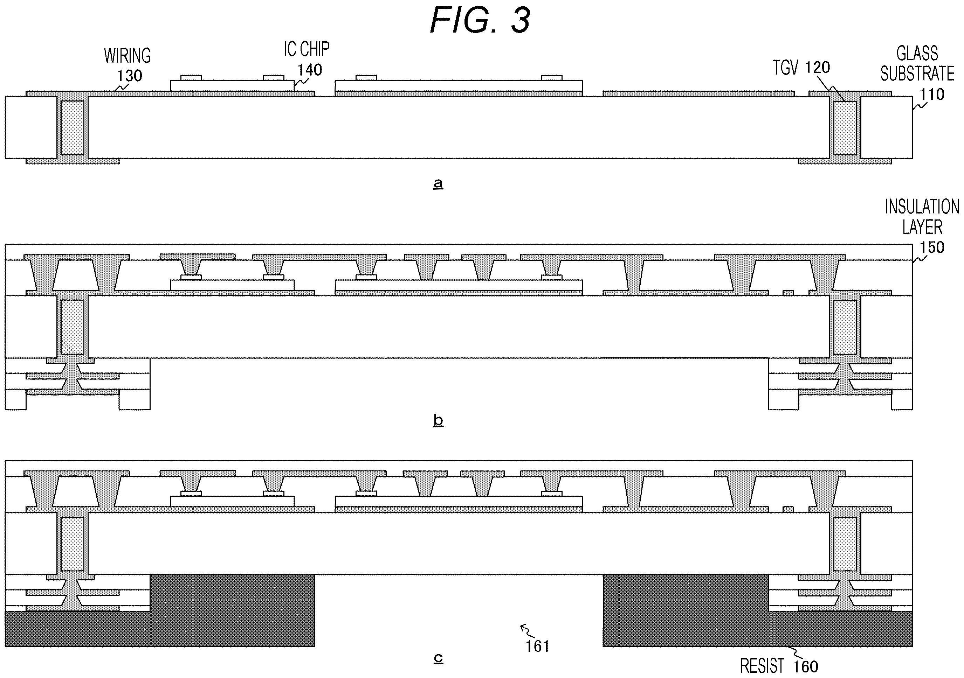

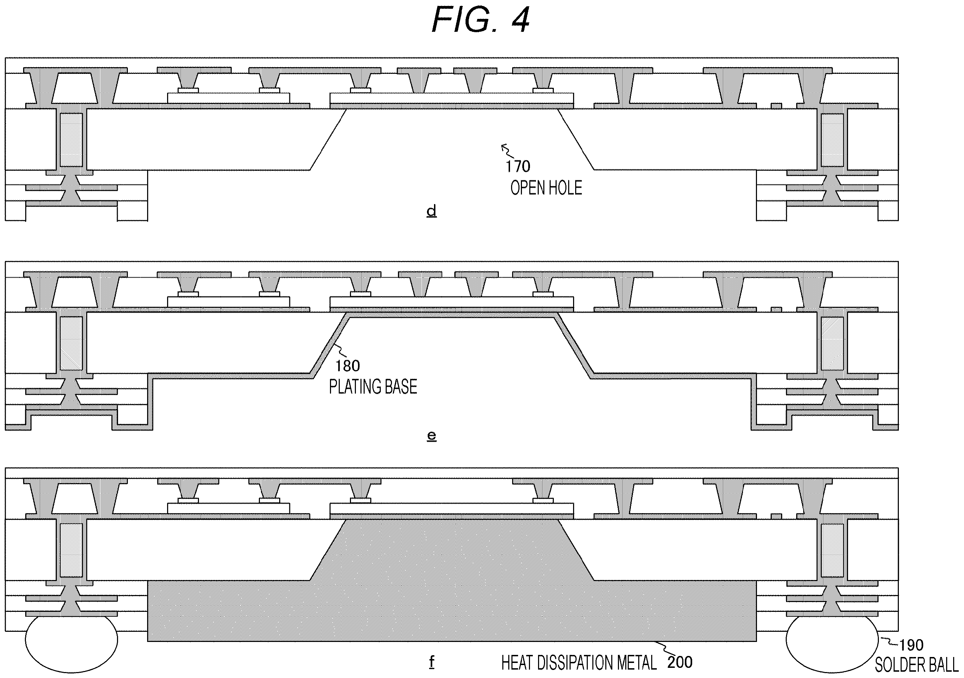

Figs. 3 and 4 are diagrams illustrating an exemplary method of manufacturing the electronic module in the first embodiment of the present technology.

As illustrated in a of Fig. 3, the IC chip 140 is die-bonded to the glass substrate 110. At this time, a silicon portion may be exposed on the back surface of the IC chip 140 that requires heat dissipation on the glass substrate 110. Furthermore, copper may be formed on the back surface of the IC chip 140.

Next, as illustrated in b of Fig. 3, insulation layers 150 and wiring layers each including the copper wiring 130 are formed as many as required on the front surface and the back surface of the glass substrate 110 on which the IC chip 140 is packaged.

Next, as illustrated in c of Fig. 3, resist 160 used to etch the glass substrate 110 is patterned. At that time, an open hole 161 is provided in the resist 160 such that the tapered shape of the glass substrate 110 has a width equal to the width of the IC chip 140 or less in the range where the thickness of the glass substrate 110 is less than 20 µm. At this time, an angle of the tapered shape formed in the glass substrate 110 is uniquely determined by appropriately selecting a kind of glass of the glass substrate 110, and etching solution.

Next, as illustrated in d of Fig. 4, the glass substrate 110 is wet-etched with the etching solution such as hydrofluoric acid or the like. After this etching, the resist 160 is peeled off.

Here, when the glass substrate 110 is etched and the back surface of the IC chip 140 is exposed, progress of etching can be stopped on the back surface of the IC chip 140 as far as silicon or copper is exposed on the back surface of the IC chip 140 as described above. With this structure, the tapered shape is formed in the glass substrate 110, and the tapered shape is formed so as not to exceed the width of the IC chip 140 in the range up to 20 µm of the thickness of glass.

Thus, the open hole 170 is formed in the glass substrate 110 by post-hole processing after the IC chip 140 is die-bonded. This functions as a stopper of the etching even when the etching solution of the glass such as hydrofluoric acid or the like contacts the back surface of the IC chip 140 due to a fact that the silicon or the copper is exposed on the back surface of the IC chip 140 as described above.

Next, as illustrated in e of Fig. 4, a plating base 180 such as a sputter film is formed on the entire back surface of the glass substrate 110 and the entire back surface of the IC chip 140. As a material of this plating base 180, Ti/Cu or the like is assumed. This plating base 180 becomes a base layer at the time of forming the heat dissipation metal 200 by electrolytic plating.

Next, as illustrated in f of Fig. 4, copper is plated by electrolytic plating only on a necessary portion in the heat dissipation metal 200 by using the metal of the plating base 180. The heat dissipation metal 200 can be used as a ground (GND) terminal by directly contacting the back surface of the IC chip 140. Furthermore, a solder ball 190 is connected to the wiring of the back surface of the glass substrate 110. With this structure, it is possible to provide electronic connection to the outside of the electronic module from the back surface side of the glass substrate 110.

Thus, in the first embodiment of the present technology, the open hole 170 is formed from the mount surface having the IC chip 140 mounted to the surface facing the mount surface in the glass substrate 110, and the heat dissipation metal 200 is formed in this open hole 170. With this structure, it is possible to ensure a sufficient heat dissipation property for the heat generated from the IC chip 140 in the module structure suitable for high-speed transmission. That is, it is possible to achieve both high-speed transmission and high heat dissipation which have a trade-off relation.

### <2. Second Embodiment>

In the first embodiment described above, a wiring layer is also provided on a back surface (a surface facing a mount surface having an IC chip 140 mounted) of a glass substrate 110 and a solder ball is connected via this wiring layer, but the present technology is also applicable to a case where a wiring layer is provided only on a front surface of the glass substrate 110. In a second embodiment, an example of connecting a solder ball via the wiring layer on the front surface of the glass substrate 110 will be described.

### [Structure]

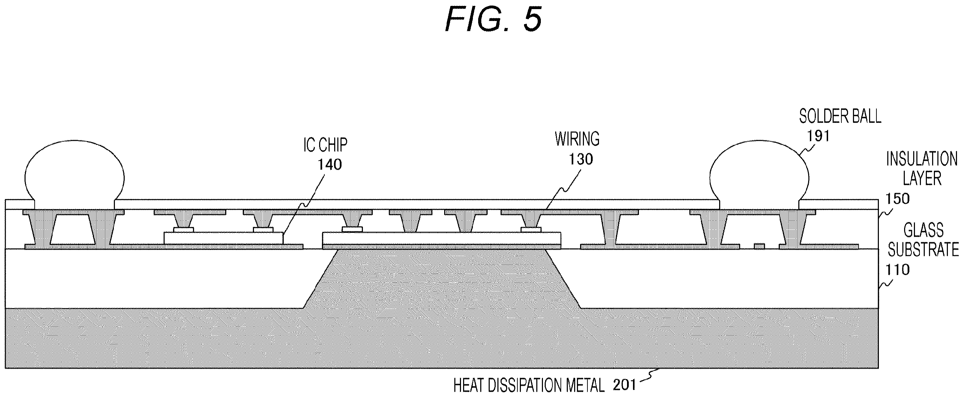

Fig. 5 is a diagram illustrating an exemplary cross-sectional view of an electronic module in the second embodiment of the present technology.

The electronic module in the second embodiment has a structure in which the glass substrate 110 and an IC chip 140 are stacked in a manner similar to the above-described first embodiment. A wiring layer including wiring 130 and an insulation layer 150 are packaged on the IC chip 140 by plating or sputtering.

In the second embodiment, no wiring layer is provided on a back surface of the glass substrate 110, and a solder ball 191 used to provide electronic connection to the outside is connected the wiring 130 on the front surface of the glass substrate 110. Note that the solder ball 191 is an example of an electronic connection member described in claims.

An open hole 170, as a through hole for heat dissipation, is formed from the mount surface having the IC chip 140 mounted to the surface facing the mount surface in the glass substrate 110. A heat dissipation metal 201 is formed in the open hole 170. Note that the heat dissipation metal 201 is an example of a heat dissipation member described in the claims.

The open hole 170 and the heat dissipation metal 201 have a tapered shape from a back surface of the IC chip 140 to the back surface of the glass substrate 110 in a manner similar to the first embodiment described above. A width of the open hole 170 is narrower than a width of the IC chip 140 on the front surface of the glass substrate 110. Additionally, the heat dissipation metal 200 forms a width sufficiently wider than the width of the IC chip 140 in a back surface portion of the glass substrate 110.

In the second embodiment, since the solder ball 191 is provided on a front surface side of the glass substrate 110 as described above, it is possible to ensure a large region for the heat dissipation metal 201. With this structure, a higher heat dissipation property can be achieved.

### [Manufacturing Method]

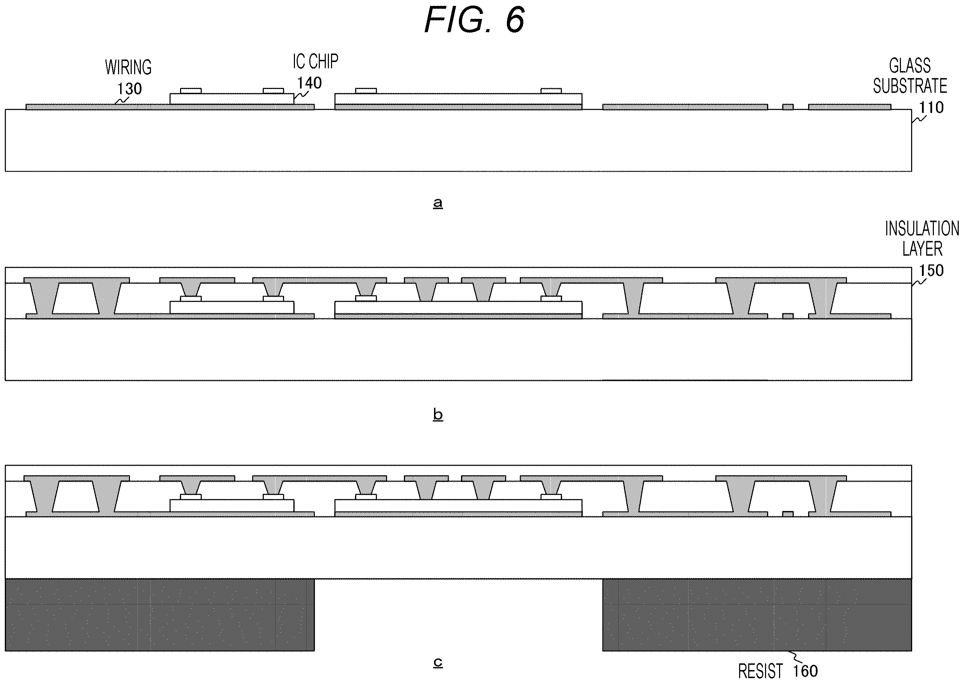

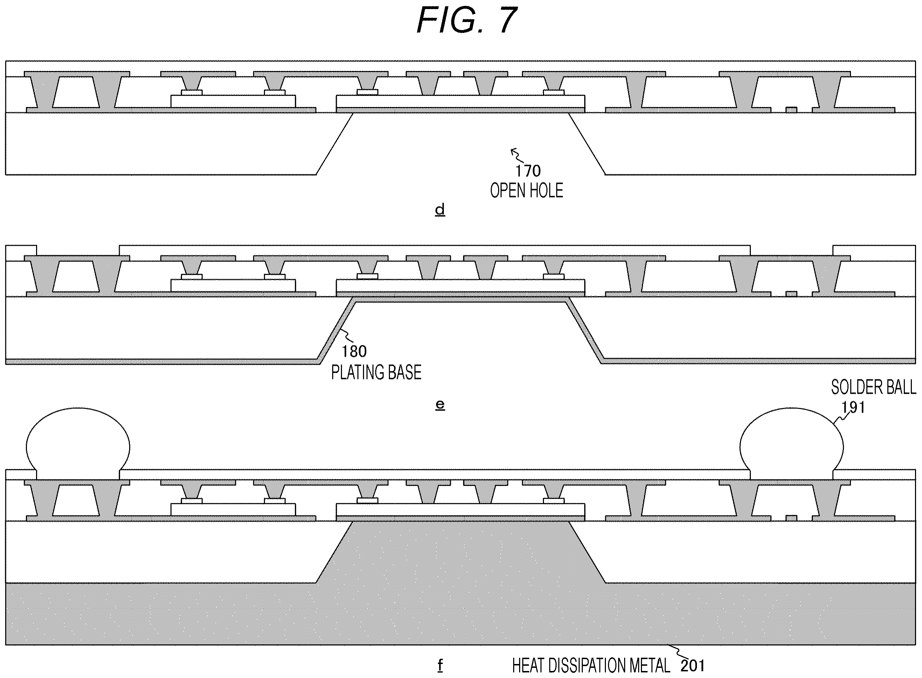

Figs. 6 and 7 are diagrams illustrating an exemplary method of manufacturing the electronic module in the second embodiment of the present technology.

As illustrated in a of Fig. 6, the IC chip 140 is die-bonded to the glass substrate 110 in a manner similar to the first embodiment.

Next, as illustrated in b of Fig. 6, insulation layers 150 and wiring layers each including the copper wiring 130 are formed as many as required on the front surface of the glass substrate 110 on which the IC chip 140 is packaged. The insulation layers and the wiring layers are formed also on the back surface of the glass substrate 110 in the above-described first embodiment, but the insulation layers and the wiring layers are formed only on the front surface of the glass substrate 110 in the second embodiment.

Next, as illustrated in c of Fig. 6, resist 160 used to etch the glass substrate 110 is patterned in a manner similar to the first embodiment.

Next, as illustrated in d of Fig. 7, the glass substrate 110 is wet-etched with etching solution such as hydrofluoric acid or the like in a manner similar to the first embodiment.

Next, as illustrated in e of Fig. 7, a plating base 180 such as a sputter film is formed on the entire back surface of the glass substrate 110 and the entire back surface of the IC chip 140 in a manner similar to the first embodiment.

Next, as illustrated in f of Fig. 7, copper is plated by electrolytic plating only on a necessary portion in the heat dissipation metal 201 by using a metal of the plating base 180 in a manner similar to the first embodiment. Furthermore, the solder ball 191 is connected to the wiring on the front surface of the glass substrate 110. With this structure, it is possible to provide electronic connection to the outside of the electronic module from the front surface side of the glass substrate 110.

Thus, according to the second embodiment of the present technology, it is possible to provide the electronic connection to the outside of the electronic module from the front surface side of the glass substrate 110 by forming the solder ball 191 on the front surface side of the glass substrate 110.

### <3. Third Embodiment>

The first and second embodiments described above have a structure in which an IC chip 140 is die-bonded to a front surface of a glass substrate 110. On the other hand, a third embodiment has a structure in which a cavity is provided in a glass substrate and an IC chip is die-bonded to the cavity.

### [Structure]

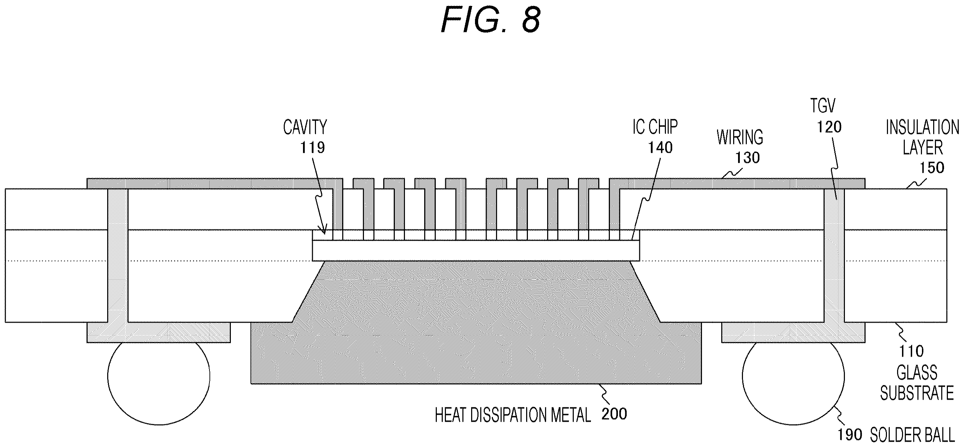

Fig. 8 is a diagram illustrating an exemplary cross-sectional view of an electronic module in the third embodiment of the present technology.

The electronic module in the third embodiment has the structure in which a glass substrate 110 includes a cavity 119, and an IC chip 140 is die-bonded to the cavity 119. Additionally, a heat dissipation metal 200 is directly formed on a back surface thereof. A wiring layer including wiring 130 and an insulation layer 150 are packaged on a front surface of the glass substrate 110 by plating or sputtering.

### [Manufacturing Method]

The insulation layer 150 and a wiring layer including the wiring 130 are formed on the front surface of the IC chip 140 embedded in the cavity 119 of the glass substrate 110 at the time of manufacturing the electronic module in the third embodiment. After that, an open hole 170 is formed by etching as a through hole for heat dissipation from a back surface of the cavity 119 of the glass substrate 110. At that time, the open hole 170 is formed in a state where the glass substrate 110 keeps a thickness illustrated in the above-described first embodiment. Then, the heat dissipation metal 200 is formed in the open hole 170 by electrolytic plating or the like.

Thus, according to the third embodiment of the present technology, the open hole 170 is provided in the glass substrate 110 in the structure in which the glass substrate 110 includes the cavity 119, and the heat dissipation metal 200 is formed so as not to adversely affect high-speed transmission in a front surface layer of the IC chip 140. With this structure, both high-speed transmission and a high heat dissipation property can be achieved in the structure in which the glass substrate 110 includes the cavity 119.

### <4. Fourth Embodiment>

In the first to third embodiments described above, it is assumed that the glass substrate 110 is used as a substrate of an electronic module. In contrast, a fourth embodiment has a structure in which an organic substrate is used and a heat dissipation metal is formed in an IC chip embedded in the organic substrate.

### [Structure]

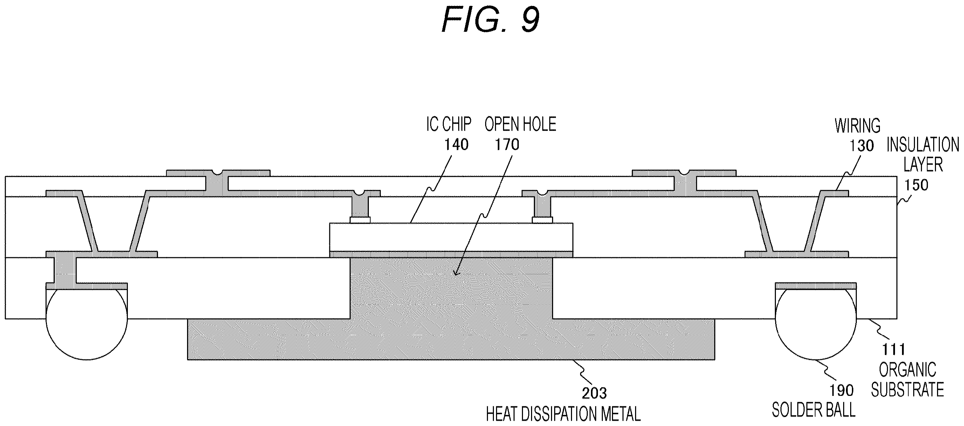

Fig. 9 is a diagram illustrating an exemplary cross-sectional view of an electronic module in the fourth embodiment of the present technology.

The electronic module in the fourth embodiment has a structure in which an IC chip 140 is built in an organic substrate 111. An open hole 170 is formed below the IC chip 140, and a heat dissipation metal 203 is formed in the open hole 170. Note that the heat dissipation metal 203 is an example of a heat dissipation member described in claims.

A width of the open hole 170 is narrower than a width of the IC chip 140 on a front surface of the organic substrate 111 in a manner similar to the first embodiment described above. Additionally, the heat dissipation metal 203 forms a width sufficiently wider than the width of the IC chip 140 in a back surface portion of the organic substrate 111.

In this example, since a manufacturing method described below is assumed, a shape from a back surface of the IC chip 140 to the back surface of the organic substrate 111 is not a tapered shape but a column shape. However, this shape may also be formed in a tapered shape.

### [Manufacturing Method]

A built-in substrate having the IC chip 140 built in the organic substrate 111 is formed at the time of manufacturing the electronic module in the fourth embodiment. At that time, a prepreg obtained by removing only a portion of the heat dissipation metal 203 is bonded before bonding the prepreg on the back surface of the organic substrate 111. This prepreg is a sheet-like reinforced plastic molding material obtained by impregnating carbon fibers with resin.

The IC chip 140 is die-bonded to a top thereof and an insulation layer 150 and a wiring layer of wiring 130 are formed. After that, the heat dissipation metal 203 is formed, by combination of electroless plating and electrolytic copper plating, on a portion where the prepreg on the back surface of the IC chip 140 is opened. With this structure, the heat dissipation metal 203 can be formed on the organic substrate 111 having the IC chip 140 built therein.

Thus, according to the fourth embodiment of the present technology, the heat dissipation metal 203 can be formed even in the structure in which the IC chip 140 is built in the organic substrate 111, and both high-speed transmission and a high heat dissipation property can be achieved.

Note that the above-described embodiments are examples to embody the present technology, and the matters described in the embodiments and matters specifying the invention in the claims have corresponding relations, respectively. Similarly, the matters specifying the invention in the claims and the matters denoted by the same names in the embodiments of the present technology have corresponding relations, respectively. However, the present technology is not limited to the embodiments and can be embodied by making various modifications on the embodiments without departing from the gist thereof.

Note that the effects described in the present specification are merely examples and not limited thereto, and furthermore, additional effects may also be provided.

Note that the present technology can also adopt the following configurations.
(1) An electronic module including a device and a substrate on which the device is mounted,
   in which the substrate includes a through hole including a hole entirely covered by the device on a device-mounted surface, and the through hole passes through from the device-mounted surface to a surface facing the device-mounted surface.
(2) The electronic module recited in (1) above,
   in which an open width of the through hole is narrower than a width of the device on the device-mounted surface.
(3) The electronic module recited in (1) or (2) above, in which
   the through hole has a tapered shape in which open area expands from the device-mounted surface to the surface facing the device-mounted surface.
(4) The electronic module recited in (3) above, in which
   an open width of the through hole is narrower than a width of the device at a position of less than 20 µm in a depth direction from the device-mounted surface.
(5) The electronic module recited in any one of (1) to (4) above,
   in which the substrate includes a glass substrate.
(6) The electronic module recited in any one of (1) to (5) above, in which
   the substrate includes a cavity, and
   the device is embedded in the cavity of the substrate.
(7) The electronic module recited in any one of (1) to (4) above, in which
   the substrate includes an organic substrate, and
   the device is built in the organic substrate.
(8) The electronic module recited in any one of (1) to (7), further including a heat dissipation member formed in the through hole.
(9) The electronic module recited in any one of (1) to (8) above, further including:
   a wiring layer formed on the device-mounted surface in the substrate;
   through wiring that is connected to the wiring layer and passes through from the device-mounted surface to the surface facing the device-mounted surface in the substrate; and
   an electronic connection member connected to the through wiring.
(10) The electronic module recited in any one of (1) to (8) above, further including:
   a wiring layer formed on the device-mounted surface in the substrate; and
   an electronic connection member connected to the wiring layer.
(11) A method of manufacturing an electronic module, including:
   a procedure of mounting a device on a substrate;
   a procedure of opening, by etching, a hole in the substrate from a surface facing a device-mounted surface to the device-mounted surface, and generating an open hole covered by the device on the device-mounted surface; and
   a procedure of generating a heat dissipation metal in the open hole by electric field plating.

### REFERENCE SIGNS LIST

- 110: Glass substrate
- 111: Organic substrate
- 119: Cavity
- 130, 131: Wiring
- 140: IC chip
- 150: Insulation layer
- 160: Resist
- 161: Open hole (resist)
- 170: Open hole (glass substrate)
- 180: Plating base
- 190, 191: Solder ball
- 200, 201, 203: Heat dissipation metal

## Claims

1. An electronic module comprising a device and a substrate on which the device is mounted,
wherein the substrate includes a through hole including a hole entirely covered by the device on a device-mounted surface, and the through hole passes through from the device-mounted surface to a surface facing the device-mounted surface.

2. The electronic module according to claim 1, wherein
an open width of the through hole is narrower than a width of the device on the device-mounted surface.

3. The electronic module according to claim 1, wherein
the through hole has a tapered shape in which open area expands from the device-mounted surface to the surface facing the device-mounted surface.

4. The electronic module according to claim 3, wherein
an open width of the through hole is narrower than a width of the device at a position of less than 20 µm in a depth direction from the device-mounted surface.

5. The electronic module according to claim 1, wherein
the substrate includes a glass substrate.

6. The electronic module according to claim 1, wherein
the substrate includes a cavity, and
the device is embedded in the cavity of the substrate.

7. The electronic module according to claim 1, wherein
the substrate includes an organic substrate, and
the device is built in the organic substrate.

8. The electronic module according to claim 1, further comprising a heat dissipation member formed in the through hole.

9. The electronic module according to claim 1, further comprising:
a wiring layer formed on the device-mounted surface in the substrate;
through wiring that is connected to the wiring layer and passes through from the device-mounted surface to the surface facing the device-mounted surface in the substrate; and
an electronic connection member connected to the through wiring.

10. The electronic module according to claim 1, further comprising:
a wiring layer formed on the device-mounted surface in the substrate; and
an electronic connection member connected to the wiring layer.

11. A method of manufacturing an electronic module, comprising:
a procedure of mounting a device on a substrate;
a procedure of opening, by etching, a hole in the substrate from a surface facing a device-mounted surface to the device-mounted surface, and generating an open hole covered by the device on the device-mounted surface; and
a procedure of generating a heat dissipation metal in the open hole by electric field plating.
